(19) Europäisches Patentamt

European Patent Office

Office européen des brevets

(11) **EP 0 938 171 B1**

(12) **FASCICULE DE BREVET EUROPEEN**

(45) Date de publication et mention
de la délivrance du brevet:
**10.11.2004   Bulletin 2004/46**

(51) Int Cl.⁷: **H01S 3/13**

(21) Numéro de dépôt: **99400369.7**

(22) Date de dépôt: **16.02.1999**

(54) **Source laser monomode continûment accordable en longueur d'onde**

Laserquelle mit kontinuierlich abstimmbarer Wellenlänge

Continuosly wavelength tunable laser source

(84) Etats contractants désignés:
**DE FR GB IT**

(30) Priorité: **20.02.1998   FR 9802105**

(43) Date de publication de la demande:
**25.08.1999   Bulletin 1999/34**

(73) Titulaire: **NETTEST PHOTONICS**
**78340 Les Clayes Sous Bois (FR)**

(72) Inventeurs:
• **Bourzeix, Sophie**
**75005 Paris (FR)**
• **Gatti, Daniel**
**78230 Le Pecq (FR)**
• **Graindorge, Philippe**
**21800 Chevigny St. Sauveur (FR)**
• **Laloux, Bernard**
**78450 Villepreux (FR)**
• **Lefevre, Hervé**
**75014 Paris (FR)**
• **Mangeot, Denis**
**78126 Aulnay s/Mauldre (FR)**
• **Martin, Philippe**
**78760 Ponchartrain (FR)**

(74) Mandataire: **Michelet, Alain et al**
**Cabinet Harlé et Phélip**
**7, rue de Madrid**
**75008 Paris (FR)**

(56) Documents cités:
**EP-A- 0 702 438          EP-A- 0 933 845**
**US-A- 5 347 527          US-A- 5 493 575**

## Description

La présente invention concerne une source laser monomode accordable en longueur d'onde à cavité externe.

On sait qu'une cavité optique résonnante d'une source laser sélectionne une ou plusieurs longueurs d'onde émises par un milieu amplificateur laser. Il s'agit le plus souvent de deux miroirs dont l'un partiellement transparent, formant une cavité dite de Fabry-Perot. Une telle cavité de Fabry-Pérot sélectionne, ou résonne pour des demi-longueurs d'onde égales à des sous-multiples de la longueur optique $L_{op}$ de la cavité et donc en général très proches les unes des autres. Plusieurs longueurs d'onde sont alors susceptibles d'être amplifiées par le milieu amplificateur à spectre large. On obtient ainsi un laser multimode.

Pour certaines applications, des lasers monomodes sont préférés. Il est alors nécessaire de mettre en oeuvre une cavité optique résonnante associant un moyen de sélection complémentaire de la cavité de Fabry-Pérot, par exemple de remplacer l'un de ses miroirs par un dispositif dispersif rétroréfléchissant.

Les dispositifs dispersifs rétroréfléchissants sont couramment utilisés en optique traditionnelle. Le dispositif le plus connu est probablement le réseau plan de pas p utilisé selon la configuration de Littrow.

De manière générale, un réseau plan de pas p a un plan de dispersion perpendiculaire à ses traits. Un faisceau lumineux collimaté de longueur d'onde $\lambda$, incliné d'un angle $\theta_1$ par rapport à la normale du réseau qui est parallèle au plan de dispersion du réseau, produit un faisceau collimaté également parallèle au plan de dispersion et ayant une direction inclinée d'un angle $\theta_2$ par rapport à la normale, $\theta_1$ et $\theta_2$ étant liés par la relation :

$$p \sin \theta_1 + p \sin \theta_2 = \lambda$$

Dans les sources lasers accordables à cavité externe fonctionnant avec une configuration dite de Littman-Metcalf où le faisceau collimaté incident fait un angle $\theta_1$ avec la normale au réseau, un miroir additionnel est placé avec sa normale ayant un angle $\theta_2$ sur le réseau. La longueur d'onde $\lambda$ qui respecte $\lambda = p \sin \theta_1 + p \sin \theta_2$ est dispersée par le réseau à un angle $\theta_2$, puis est rétroréfléchie sur le miroir qui lui est alors perpendiculaire, et enfin est dispersée de nouveau dans le réseau en retour et ressort à l'angle $\theta_1$ d'entrée. Cette longueur d'onde $\lambda$ est donc sélectionnée dans la cavité. L'accordabilité en longueur d'onde est obtenue en faisant varier l'orientation de l'ensemble réseau-miroir, c'est-à-dire en faisant varier $\theta_1$, ou bien en faisant varier uniquement l'orientation du miroir, c'est-à-dire en faisant varier $\theta_2$ ou enfin en faisant varier uniquement l'orientation du réseau, c'est-à-dire en faisant varier $\theta_1$ et $\theta_2$ tout en conservant $\theta_1 - \theta_2$ constant.

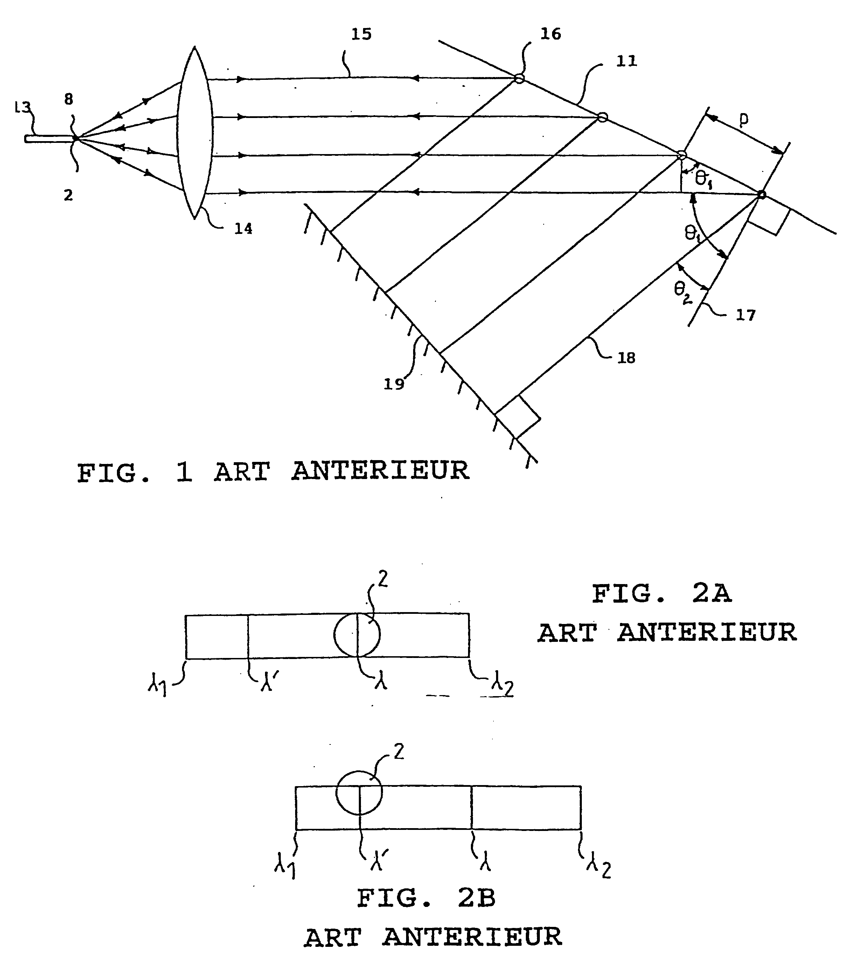

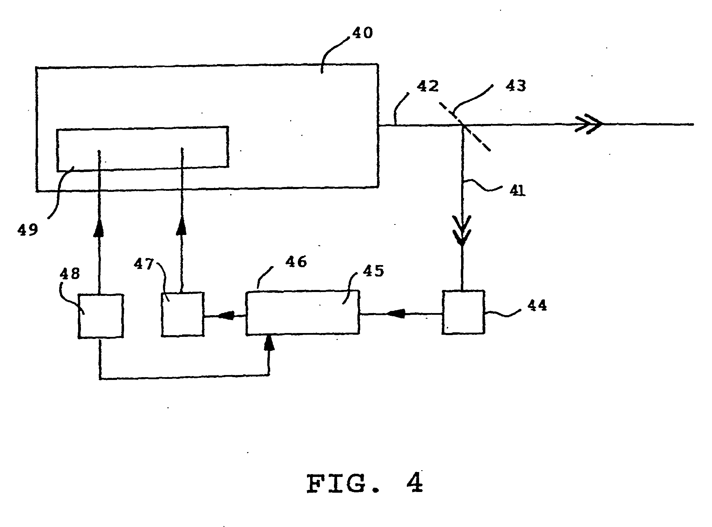

La Figure 1 représente un réseau 11 mis en oeuvre selon le montage de Littman-Metcalf dans lequel une extrémité 2 d'un milieu amplificateur monomode guidé 13 est placée au foyer d'une optique de collimation 14 qui produit un faisceau collimaté principal 15 de longueur d'onde $\lambda$.

Ce faisceau est parallèle au plan de dispersion du réseau, c'est-à-dire au plan perpendiculaire aux traits 16 du réseau 11, et forme un angle $\theta_1$ avec la normale 17 à la surface du réseau 11. Par diffraction sur le réseau, le faisceau 15 produit un faisceau collimaté secondaire 18 qui est dans le plan de dispersion et forme un angle $\theta_2$ avec la normale 17. Un miroir plan 19 est placé perpendiculairement au faisceau 18 et le faisceau se rétroréfléchit à travers l'ensemble du système.

On sait dans ces conditions que p étant le pas du réseau, lorsque la relation $p \sin \theta_1 + p \sin \theta_2 = \lambda$ est vérifiée, le faisceau 15 revient sur lui-même après une première diffraction sur le réseau 11, une rétroréflexion sur le miroir 19 et une deuxième diffraction sur le réseau 11. Il produit donc un point-image 8 confondu avec l'extrémité 2.

Le réglage de tels dispositifs nécessite le positionnement précis du réseau autour d'un axe perpendiculaire à l'axe de sélection et parallèle au plan de dispersion. Ce dernier réglage et sa stabilité sont très délicats et conditionnent, dans la plupart des cas, la qualité du résultat obtenu.

Afin d'éclaircir cet exposé, on a représenté sur la Figure 2A une vue du plan focal de l'optique de collimation 14, dans lequel se trouve l'extrémité 2 d'un milieu amplificateur guidé et le spectre produit en retour par les montages de la Figure 1, lorsque l'amplificateur émet un spectre large. On obtient ainsi un spectre s'étendant d'une longueur d'onde $\lambda_1$ à une longueur d'onde $\lambda_2$, et pour lequel la longueur d'onde $\lambda$ est rétroréfléchie sur l'extrémité 2 et est donc sélectionnée dans la cavité.

En pratique, l'axe de rotation réel ne pouvant être exactement parallèle aux traits du réseau, le déplacement du spectre dans le plan focal s'accompagne d'un mouvement perpendiculaire à celui-ci et conduit, lorsque la longueur d'onde $\lambda'$ sera rétroréfléchie, à une configuration telle que celle représentée sur la Figure 2B, dans laquelle la rétroréflexion n'est pas exactement obtenue en raison du décalage du spectre, perpendiculairement à lui-même, en même temps que parallèlement à lui-même dans le plan focal de l'optique de collimation.

Dans la configuration de Littman-Metcalf, ce problème se pose quand le réseau 11, ou bien le miroir 19 ou bien l'ensemble des deux, subissent une rotation autour d'un axe parallèle aux traits 16 du réseau.

De tels dispositifs peuvent aussi générer des sauts de modes. En effet, la rotation du dispositif dispersif à réseau change la longueur d'onde sélectionnée mais cette longueur d'onde doit aussi respecter la condition de résonance de toute cavité optique qui indique que la longueur optique $L_{op}$ de la cavité (en aller simple) est égale à un nombre entier N de demi-longueur d'onde :

$$L_{op} = N \cdot \lambda / 2$$

Si la longueur d'onde sélectionnée diminue, il faut donc raccourcir en même temps la cavité, et inversement la rallonger quand la longueur d'onde augmente, pour rester sur le même nombre entier N et éviter les sauts de modes.

Un dispositif d'accordabilité continue sans saut de mode a été proposé avec une configuration de Littrow (distincte de la configuration de Littman-Metcalf (F. Favre et D. Le Guen, *"82 nm of continuous tunability for an external cavity semi-conductor laser"*, Electronics Letters, Vol. 27, 183-184, [1991]), mais il nécessite un ensemble mécanique complexe utilisant deux mouvements de translation et deux mouvements de rotation.

Dans un article de 1981, Liu et Littman (Optics Letters, vol. 6, N° 3, Mars 1981, pp. 117-118) décrivent un dispositif comportant un réseau et un miroir d'orientation variable mis en oeuvre pour la réalisation d'un laser monomode de longueur d'onde variable. La géométrie proposée permet d'assurer un balayage en longueur d'onde sans rupture.

Par ailleurs, les dièdres réflecteurs ont été étudiés de longue date. En particulier, la demande de brevet japonais JP-A-57.099793 du 21 Juin 1981 propose d'utiliser un tel dièdre pour réaliser un dispositif dispersif rétroréfléchissant dans un système de communication à fibre optique multiplexé en longueurs d'onde, ces longueurs sont fixes.

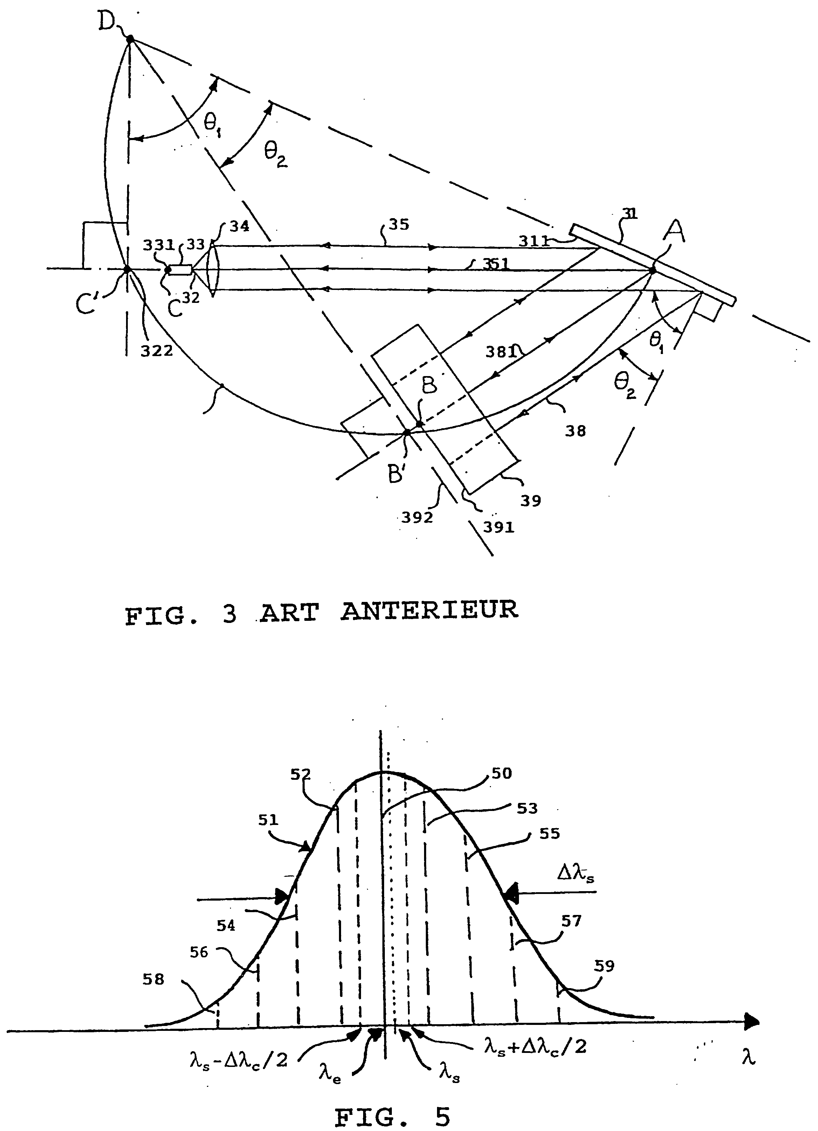

On connaît également une telle source laser monomode accordable en continu décrite dans la demande de brevet européen 0.702.438 qui utilise une configuration de Littman-Metcalf définie par référence à la Figure 3 du présent titre, comportant un réseau plan 31, un dièdre réflecteur orthogonal 39 dont l'arête 391 est parallèle au plan de dispersion du réseau 31 comprenant les axes de collimation.

Le point A est le point d'intersection des axes de collimation et du réseau, le point B' est l'extrémité optique de la cavité située du côté du système dispersif, le point C' est l'intersection de l'axe de collimation principal avec l'extrémité optique de la cavité située du côté du milieu amplificateur, le point D est l'intersection du plan contenant la phase de diffraction du réseau et de la parallèle à l'arête du dièdre passant par B'.

L'angle AC'D est maintenu égal à 90° et la longueur AD est maintenue constante.

Un tel dispositif dans lequel le respect de ces conditions est obtenu avec des moyens purement mécaniques, donne pour l'essentiel satisfaction. Toutefois, il a été jugé utile d'améliorer encore ce dispositif de façon à faciliter son réglage.

L'objectif de l'invention est donc de proposer une source laser monomode continûment accordable à cavité externe dont la facilité de réglage soit améliorée, qui puisse donc être réalisée dans les meilleures conditions économiques et assurer une bonne stabilité dès son premier fonctionnement et pendant toute sa durée de vie.

A cet effet, l'invention, définie dans la revendication 1, concerne donc une source laser monomode continûment accordable en longueur d'onde, à cavité externe. Elle comporte une cavité résonnante, résonnant à la longueur d'onde d'émission $\lambda_e$, ayant :

- un guide d'onde amplificateur, spatialement monomode, placé à l'intérieur de la cavité résonnante, ledit guide d'onde ayant une face intracavité revêtue d'un traitement antiréfléchissant,
- une optique de collimation ayant un foyer, ladite face intracavité du guide d'onde étant placée au foyer de cette optique,
- une face de sortie partiellement réfléchissante,
- un dispositif dispersif en longueur d'onde rétroréfléchissant disposé par rapport au guide d'onde et à l'optique de collimation, de telle sorte qu'ils produisent une courbe de sélectivité en longueur d'onde présentant un maximum $\lambda_s$, et
- des moyens mécaniques primaires permettant d'assurer approximativement l'accordabilité continue.

Selon l'invention, elle comporte des moyens additionnels de contrôle fin permettant, à partir de la position approximative d'accordabilité continue, d'asservir la position du dispositif dispersif rétroréfléchissant, de façon à contrôler l'écart $\lambda_e - \lambda_s$ pendant la variation de la longueur d'onde d'émission $\lambda_e$ en évitant que cet écart n'atteigne l'une des limites produisant des sauts de mode.

Une telle disposition permet d'éviter les imperfections résultant nécessairement d'un réglage mécanique et permet d'assurer la continuité de la variation en longueur d'onde et de la rattraper tant que ses fluctuations restent inférieures à plus ou moins $\Delta\lambda_e/2$ où $\Delta\lambda_e$ est la distance entre deux modes successifs de résonance de la cavité.

De manière avantageuse :

- les moyens de contrôle comportent :

  un générateur de modulation de $\lambda_e - \lambda_s$,
  un démodulateur de l'intensité du flux lumineux mesuré produisant un signal démodulé utilisé pour asservir la position du dispositif dispersif rétroréfléchissant;

- l'écart moyen $< \lambda_e - \lambda_s >$ est asservi à une valeur $\Delta\lambda_o$ supérieure à zéro ;
- l'écart $< \lambda_e - \lambda_s >$ est asservi à zéro ;
- le contrôle et la modulation de $\lambda_e - \lambda_s$ sont obtenus

par le contrôle et la modulation de la longueur d'onde $\lambda_s$ du maximum de la courbe de sélectivité du dispositif dispersif rétroréfléchissant ;

- le contrôle et la modulation de la longueur d'onde $\lambda_s$ sont obtenus par une rotation additionnelle de l'un des éléments du dispositif dispersif rétroréfléchissant ;

- le contrôle et la modulation de la longueur d'onde $\lambda_s$ sont obtenus par la rotation additionnelle du réflecteur ;

- le contrôle et la modulation de $\lambda_e$ - $\lambda_s$ sont obtenus par le contrôle et la modulation de la longueur d'onde $\lambda_e$ ;

- le contrôle et la modulation de la longueur d'onde $\lambda_e$ sont obtenus par une translation additionnelle de l'un des éléments de la cavité résonnante ;

- le dispositif dispersif rétroréfléchissant comporte un réflecteur, le contrôle et la modulation de la longueur d'onde d'émission $\lambda_e$ sont obtenus par une translation additionnelle dudit réflecteur.

L'invention sera décrite plus en détail en référence aux dessins dans lesquels :

- la Figure 1 est une représentation schématique d'un montage traditionnel, de l'art antérieur, selon la configuration de Littman-Metcalf ;

- les Figures 2A et 2B sont une représentation schématique du spectre réfléchi dans le plan de la source pour deux réglages différents des éléments de la Figure 1 ;

- la Figure 3 est une représentation schématique d'une cavité laser continûment accordable et autoalignée selon l'art antérieur ;

- la Figure 4 est une représentation schématique des blocs de contrôle et de modulation de la source ;

- la Figure 5 est une représentation de la raie laser émise par la source par rapport aux autres modes longitudinaux de la cavité de Fabry-Pérot et à la courbe de sélectivité, en longueur d'onde, du dispositif dispersifrétroréfléchissant ;

- la Figure 6 est une représentation de la zone de fonctionnement de la source sans saut de mode, au seuil ;

- la Figure 7 est une représentation de la zone de fonctionnement de la source sans saut de mode, dans les conditions normales de fonctionnement ;

- les Figures 8 et 9 sont des représentations schématiques de la modulation utilisée pour l'asservissement ;

- la Figure 10 est un exemple de réalisation concret de la source de l'invention.

Pour améliorer le fonctionnement d'une source laser monomode continûment accordable à cavité externe, telle que celle décrite plus haut en référence à la Figure 3, la source de l'invention comporte des moyens de contrôle et de modulation de l'écart $\lambda_e$ - $\lambda_s$

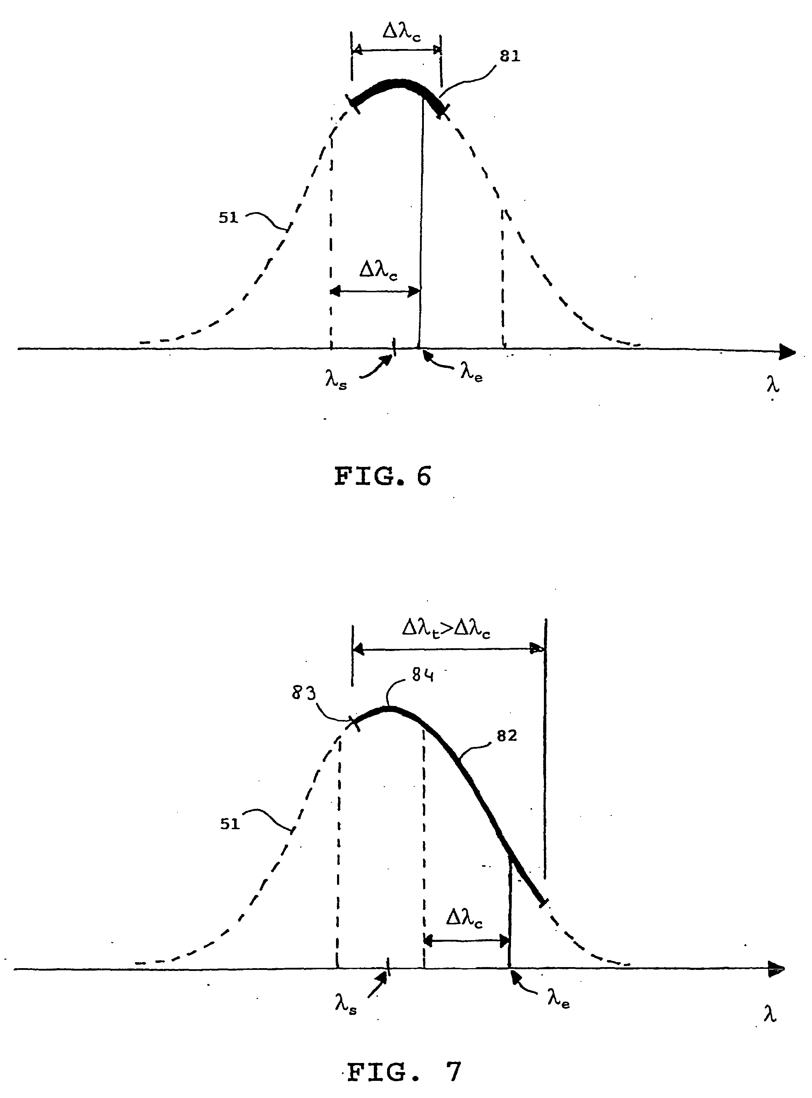

pendant la variation de la longueur d'onde d'émission $\lambda_e$. Ces moyens de contrôle et de modulation sont représentés sur la Figure 4.

Une partie 41 du flux lumineux 42 émis par la source 40 est prélevée par un moyen de séparation 43 et mesurée par un détecteur photoélectrique 44, fournissant éventuellement par l'intermédiaire d'une première unité de traitement 45, une mesure de l'écart $\lambda_e$ - $\lambda_s$ qui, par les moyens de commande 47, agit sur l'actuateur 49 de la source 40 pour contrôler cet écart $\lambda_e$ - $\lambda_s$.

Avantageusement, un modulateur 48 agit sur l'actuateur 49 de la source 40 de façon à moduler à une fréquence f, l'écart $\lambda_e$ - $\lambda_s$, l'écart $\lambda_e$ - $\lambda_s$ est alors la somme d'un écart moyen < $\lambda_e$ - $\lambda_s$ > et de la modulation. Dans ce cas, l'unité de traitement 45 comporte un démodulateur 46 relié au générateur de modulation 48 qui lui permet d'extraire du signal électrique modulé fourni par le photodétecteur 44, la composante démodulée dépendant de l'écart < $\lambda_e$ - $\lambda_s$ >.

Cette composante démodulée sert alors de signal d'erreur pour une boucle d'asservissement où des moyens de commande 47 agissent sur l'actuateur 49 pour contrôler l'écart moyen < $\lambda_e$ - $\lambda_s$ >.

Cette disposition qui s'est avérée particulièrement efficace, paraît appliquer la théorie suivante. Lorsqu'un réglage purement mécanique, tel que celui incorporé dans une source de l'art antérieur représenté plus haut en référence à la figure 3, assure le respect des conditions d'accordabilité continue, en supposant la source bien réglée, le mode unique d'émission a un maximum de puissance à la longueur d'onde $\lambda_e$ qui coïncide avec la valeur $\lambda_s$ , longueur d'onde du maximum de la courbe de sélectivité. Cette coïncidence est maintenue quand le dispositif dispersif rétroréfléchissant a une de ces composantes mise en rotation pour changer la longueur d'onde d'émission. Le réglage mécanique n'est cependant pas parfait et, en pratique, l'écart entre les longueurs d'onde $\lambda_e$ et $\lambda_s$ ne reste pas maintenu à zéro, il fluctue. Tant que l'amplitude de ces fluctuations reste dans la plage de $\lambda_s$ - $\Delta\lambda_c/2$ à $\lambda_s$ + $\Delta\lambda_c/2$ (où $\Delta\lambda_c = \lambda^2_e/2L_{op}$ est l'espacement des modes longitudinaux de la cavité), la source accordable continue à fonctionner sur le même mode longitudinal sans saut de mode. On a toutefois constaté que, si la puissance de la source est changée par modification du gain dans le guide d'onde 33 amplificateur, celle-ci entraîne une modification de l'indice de ce guide, donc une variation de la longueur optique $L_{op}$ de la cavité et, par conséquent, de $\lambda_e$. Lorsque le réglage mécanique a été maintenu constant, les fluctuations de l'écart $\lambda_e$ - $\lambda_s$ restent identiques en amplitude, mais ne sont plus centrées sur 0 car elles ont été translatées par la variation d'indice du guide d'onde. Lorsque ces fluctuations conduisent $\lambda_e$ à dépasser les limites $\lambda_s$ - $\Delta\lambda_c/2$ ou $\lambda_s$ + $\Delta\lambda_c/2$ , on constate un saut de mode qui décale brutalement la longueur d'onde d'émission $\lambda_e$ de $\Delta\lambda_c$ ou de - $\Delta\lambda_c$ respectivement.

Le contrôle électromécanique des écarts rési-

duels $\lambda_e$ - $\lambda_s$ permet d'éviter ces sauts de mode.

Sur la Figure 5, on a représenté la raie laser émise 50 à la longueur d'onde $\lambda_e$ par rapport à la courbe 51 de sélectivité en longueur d'onde du dispositif dispersif rétroréfléchissant centrée sur la longueur d'onde $\lambda_s$ et de largeur à mi-hauteur $\Delta\lambda_s$ ainsi que les autres modes longitudinaux 52 à 59 de la cavité Fabry-Pérot.

Tant que la valeur absolue de l'écart $\lambda_e$ - $\lambda_s$ reste inférieure à $\Delta\lambda_c/2$, la raie d'émission 50 coïncide avec le mode de la cavité de Fabry-Pérot subissant la plus forte amplification. Lorsque la valeur absolue de l'écart $\lambda_e$ - $\lambda_s$ devient supérieure à $\Delta\lambda_c/2$, l'un des modes longitudinaux 52, 53 de la cavité Fabry-Perot placés de part et d'autre de $\lambda_e$ est susceptible de subir un taux d'amplification supérieur à celui à la longueur d'onde $\lambda_e$ et peut définir la longueur d'onde d'émission au détriment de la précédente. Il y a donc, en l'absence de contrôle, un saut de mode que le contrôle de l'écart $\lambda_e$ - $\lambda_s$ selon l'invention permet d'éviter.

Le contrôle et/ou la modulation de l'écart $\lambda_e$ - $\lambda_s$ peut être obtenu en contrôlant et/ou en modulant $\lambda_e$ ou $\lambda_s$. La Figure 6 représente la plage 81 de fonctionnement sans saut de mode. Cette plage 81 centrée sur $\lambda_s$ a une largeur $\Delta\lambda_c$.

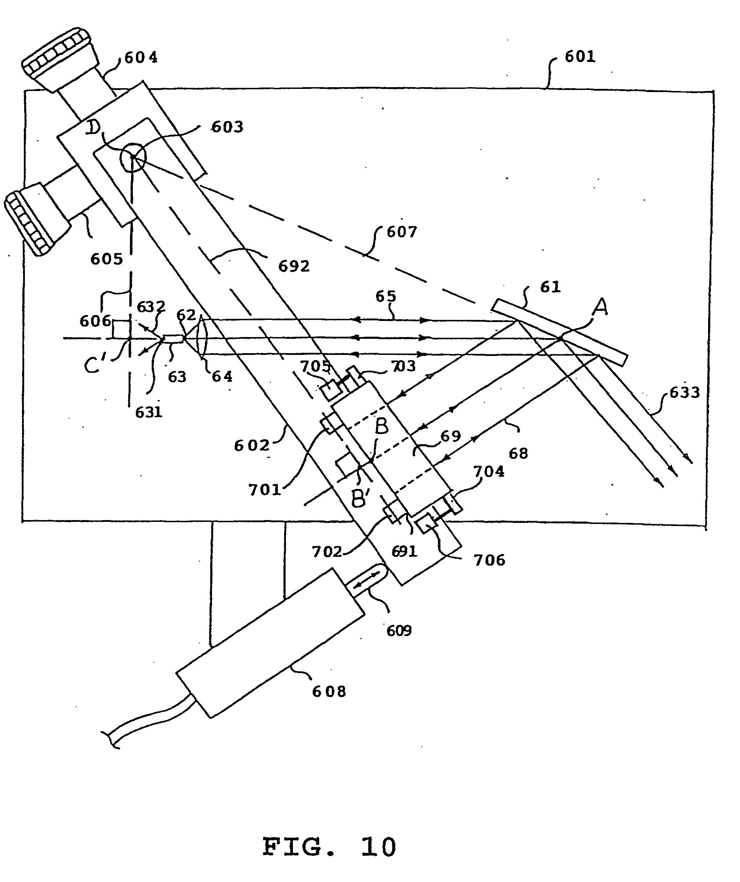

La source de l'invention est avantageusement réalisée conformément à la Figure 10 dans laquelle le dispositif dispersif rétroréfléchissant comporte un réseau fixe 61 et un dièdre 69 monté sur un support mobile 602 qui peut tourner autour de l'axe perpendiculaire au plan de dispersion du réseau 61 et passant par D.

Le réseau 61, le milieu amplificateur guidé monomode 63 comportant une face intracavité 62, et l'objectif de collimation 64 sont fixés sur un bâti 601. Le dièdre 69 est fixé sur un support mobile primaire 602 tournant autour d'un axe excentré 603, de façon à ce que la droite 692 parallèle à l'arête 691 passant par le point B' qui est l'extrémité optique de la cavité, passe aussi par l'axe 603.

Cet axe 603 est fixé sur un ensemble de mouvements de translation 604 et 605 qui permettent de le positionner à l'intersection D de la perpendiculaire 606 à l'axe de la cavité qui passe par C', et de la droite 607 passant par la face du réseau 61. Un moteur 608, fixé sur le bâti 601, actionne une tige 609 qui entraîne la rotation autour de l'axe 603 du support primaire 602 et du dièdre 69 qui y est fixé. Ainsi, le faisceau diffracté 68 qui est sélectionné dans la cavité reste perpendiculaire à l'arête 691.

Pendant une rotation du support mobile 602, le faisceau 68 se déplace latéralement sur le dièdre 69, ainsi que B', le long de la droite 692. Ce déplacement du faisceau est une translation géométrique de celui-ci qui n'implique pas de translation de pièces mécaniques.

Cette disposition permet un réglage approximatif, purement mécanique de l'accordabilité continue, particulièrement pratique du point de vue de l'agencement mécanique, car elle utilise une simple rotation mécanique du support primaire. Notons que le point B' peut être décalé par rapport à la position indiquée plus haut, raccourcissant ou allongeant ainsi la cavité. Il est alors possible de retrouver la même condition d'accordabilité continue par rotation autour de D en déplaçant le point C' d'une même longueur mais en sens inverse pour compenser ce décalage, dû au déplacement de B'.

Cette source accordable délivre un faisceau divergent 632 à la sortie 631 du milieu amplificateur 63, mais il est aussi possible d'utiliser facilement le faisceau collimaté 633 qui correspond à la réflexion ordinaire du faisceau 65 sur le réseau 61. Cette réflexion ordinaire, appelée aussi ordre zéro du réseau, garde une direction fixe car le réseau est fixé au bâti et seul le dièdre est mobile pendant le réglage en longueur d'onde.

Le contrôle et/ou la modulation de l'écart $\lambda_e$ - $\lambda_s$ est avantageusement géré par le contrôle et/ou la modulation de $\lambda_s$. Ceci peut être obtenu en agissant sur la position et/ou sur l'orientation angulaire additionnelle du réflecteur 69 autour d'un axe perpendiculaire au plan de dispersion. A cet effet, celui-ci est fixé sur le bras 602 par l'intermédiaire de moyens de fixation articulés 701 et 702, et il est solidaire de surfaces d'appui 703 et 704 qui coopèrent avec des actuateurs piézo-électriques 705 et 706 solidaires du support primaire 602. Les actuateurs 705 et 706 peuvent aussi être simplement interposés entre le support primaire 602 et le réflecteur 69. Le support primaire 602 permet d'assurer le réglage approximatif et les actuateurs 705 et 706 permettent le contrôle fin.

Ces actuateurs piézo-électriques 705, 706, correspondant à l'actuateur 49 de la Figure 4, sont commandés par les moyens de commande 47 en ce qui concerne le contrôle de l'écart moyen < <$\lambda_e$ - $\lambda_s$> et par le générateur de modulation 48 en ce qui concerne sa modulation.

De façon analogue et non représentée, cette modulation et/ou contrôle de $\lambda_s$ peut être commandée en agissant sur l'orientation angulaire du réseau 61.

Il est encore possible pour contrôler et/ou moduler l'écart $\lambda_e$ - $\lambda_s$ d'agir sur $\lambda_e$, c'est-à-dire sur la longueur optique $L_{op}$ de la cavité. Cette variation de la longueur $L_{op}$ de la cavité peut être réalisée par une translation du réflecteur 69 ou du réseau 61. On peut encore moduler l'indice optique d'un élément de la cavité, soit du guide amplificateur 63, soit d'un élément additionnel ajouté à cet effet dont on peut faire varier l'indice de façon contrôlée. On peut aussi agir sur la position transverse parallèlement au plan de dispersion de l'objectif de collimation 64 par rapport au milieu amplificateur guidé 63 qui détermine l'orientation du faisceau collimaté 65.

Il est souvent utile de réduire l'écart moyen < <$\lambda_e$ - $\lambda_s$> à zéro, ramenant ainsi la longueur d'onde du mode d'émission $\lambda_e$ au maximum $\lambda_s$ de la courbe de sélectivité du dispositif dispersif rétroréfléchissant. On obtient la puissance optique maximum. Dans ce cas, la boucle d'asservissement est conçue de façon que le signal d'erreur démodulé soit ramené à zéro.

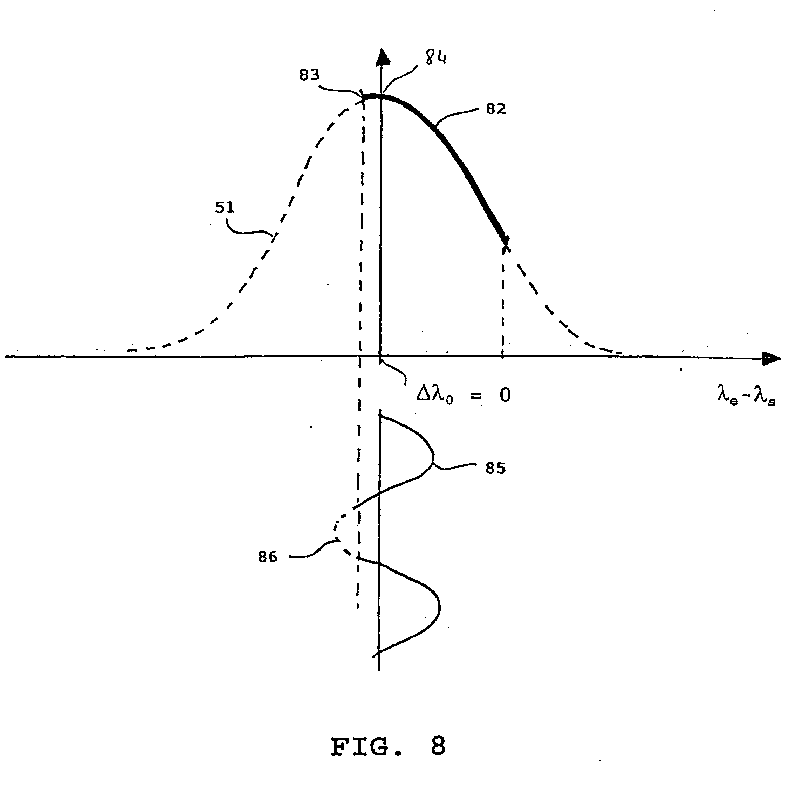

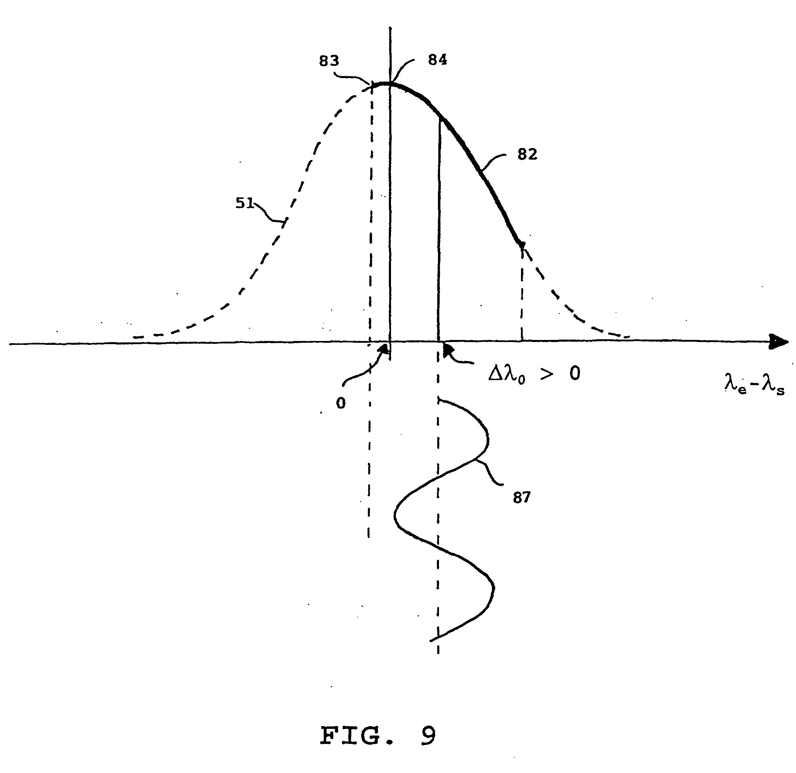

En pratique, il a été constaté qu'il est préférable de fixer l'asservissement de l'écart moyen $< \lambda_e - \lambda_s >$ non pas à la valeur nulle, mais à une valeur positive $\Delta\lambda_o$ de l'ordre de $\Delta\lambda_c/5$ à $\Delta\lambda_c$. C'est ce qui est représenté sur la Figure 9. En effet, il a été constaté que la théorie explicative des sauts de mode présentée plus haut, ne correspond plus à la réalité lorsque le fonctionnement est éloigné du seuil laser. En pratique, quand la puissance émise par la source augmente, des phénomènes complexes interviennent produisant des effets d'hystérésis et d'asymétrie. La source peut alors fonctionner sans saut de mode sur une plage de largeur $\Delta\lambda_t$ supérieure à $\Delta\lambda_c$, mais il a été constaté que cette plage 82 de fonctionnement sans saut de mode est décalée vers les grandes longueurs d'onde par rapport à $\lambda_s$ (Figure 7). Un réglage au maximum 84 (écart moyen $< <\lambda_e - \lambda_s >$ = 0) présente alors des risques importants de saut de mode car la limite 83 vers les longueurs d'onde inférieures de ces sauts est proche de $\lambda_s$ et une faible fluctuation de l'écart $\lambda_e - \lambda_s$, éventuellement due à la modulation, pourrait produire le dépassement de cette frontière et donc un saut de mode (Figure 8). Il est même possible, dans le cas de très fortes puissances, que cette limite 83 vers les longueurs d'onde inférieures dépasse $\lambda_s$.

La valeur choisie pour $\Delta\lambda_o = < \lambda_e - \lambda_s >$ résulte d'un compromis : $\Delta\lambda_o$ doit être suffisamment important pour éloigner $\lambda_e$ de la limite inférieure 83 des sauts de mode mais pas trop grand pour maintenir une puissance suffisante ; cette puissance se dégrade lorsque $\lambda_e$ s'éloigne de $\lambda_s$ qui correspond au maximum 84 de la courbe de sélectivité.

La modulation 85, 87 de l'écart $\lambda_e - \lambda_s$ a été représentée sur les Figures 8 et 9. Sur la Figure 8, $\Delta\lambda_o = <\lambda_e - \lambda_s>$ étant nul, la modulation 85 conduit à dépasser dans la zone 86, la limite inférieure 83, ce qui engendre un saut de mode. Sur la Figure 9, le choix d'une valeur $\Delta\lambda_o = < \lambda_e - \lambda_s >$ positive suffisante évite que la modulation 87 dépasse la limite inférieure 83, sans pour autant trop s'éloigner du maximum 84 de la courbe de sélectivité.

Dans un exemple de réalisation particulièrement intéressant, on cherche à réaliser une source travaillant autour d'une longueur d'onde de l'ordre de 1550 nm.

La longueur de la cavité peut alors être avantageusement $L_{op}$ = 30 mm (30 mm aller simple), l'espacement $\Delta\lambda_c$ des modes longitudinaux est de l'ordre de 40 pm et la largeur à mi-hauteur $\Delta\lambda_s$ de la courbe de sélectivité est de l'ordre de 200 pm.

On contrôlera et/ou on module de préférence l'écart $\lambda_e - \lambda_s$ par un mouvement de rotation additionnelle du réflecteur 69.

L'amplitude de modulation de l'écart $\lambda_e - \lambda_s$ est typiquement de 10 pm, soit $\Delta\lambda_c/4$ et la fréquence de modulation et de l'ordre de 5 à 10 kHz. Le dièdre réflecteur pouvant être très léger, un tel mouvement à une telle fréquence est obtenu sans problème avec moins d'un Volt de modulation sur des céramiques piézo-électriques classiques.

Pour le contrôle et l'asservissement de $\lambda_e - \lambda_s$ sur $\Delta\lambda_o$ qui rattrape des défauts du système mécanique primaire, l'amplitude de la compensation est en pratique liée à la tension électrique disponible pour commander les actuateurs. Un bon ordre de grandeur est de rattraper quelques $\Delta\lambda_c$ (soit quelques sauts de mode) avec quelques dizaines de Volts;

Les signes de référence insérés après les caractéristiques techniques mentionnées dans les revendications, ont pour seul but de faciliter la compréhension de ces dernières, et n'en limitent aucunement la portée.

## Revendications

1.　Source laser monomode continûment accordable en longueur d'onde, à cavité externe, comportant une cavité résonnante, résonnant à la longueur d'onde d'émission $\lambda_e$, ayant :

- un guide d'onde amplificateur, spatialement monomode, placé à l'intérieur de la cavité résonnante, ledit guide d'onde ayant une face intracavité revêtue d'un traitement antiréfléchissant,
- une optique de collimation ayant un foyer, ladite face intracavité du guide d'onde étant placée au foyer de cette optique,
- une face de sortie partiellement réfléchissante,
- des moyens d'extraction d'une partie du flux intracavité,
- un dispositif dispersif en longueur d'onde rétroréfléchissant, asservi en position et ou en orientation, disposé par rapport au guide d'onde et à l'optique de collimation, de telle sorte qu'il produit une courbe de sélectivité en longueur d'onde présentant un maximum pour $\lambda_s$ et,
- des moyens mécaniques primaires permettant d'assurer approximativement l'accordabilité continue,

　**caractérisée en ce que**, elle comporte des moyens additionnels de contrôle fin permettant, à partir de la position approximative d'accordabilité continue, de contrôler l'écart $\lambda_e - \lambda_s$ pendant la variation de la longueur d'onde d'émission $\lambda_e$ en évitant que cet écart atteigne l'une des limites produisant des sauts de mode.

2.　Source laser monomode continûment accordable en longueur d'onde selon la revendication 1, **caractérisée en ce que** les moyens de contrôle fin agissent sur au moins une des positions et/ou l'orientation du dispositif sitif rétroréfléchissant.

**3.** Source laser monomode continûment accordable en longueur d'onde selon l'une des revendications 1 et 2, **caractérisée en ce que** les moyens de contrôle comportent :

- un générateur de modulation (48) de $\lambda_e$ - $\lambda_s$,
- un démodulateur (46) de l'intensité du flux lumineux mesuré produisant un signal démodulé utilisé pour asservir la position du dispositif dispersif rétroréfléchissant.

**4.** Source laser monomode continûment accordable en longueur d'onde selon l'une des revendications 1 à 3, **caractérisée en ce que** l'écart moyen < $\lambda_e$ - $\lambda_s$ > est amené à une valeur de consigne $\Delta\lambda_o$ supérieure à zéro, par une boucle d'asservissement de la position et/ou de l'orientation du dispositif dispersif rétroréfléchissant.

**5.** Source laser monomode continûment accordable en longueur d'onde selon l'une des revendications 1 à 3, **caractérisée en ce que** l'écart moyen < $\lambda_e$ - $\lambda_s$ > est réduit à zéro, par une boucle d'asservissement de la position et/ou de l'orientation du dispositif dispersif rétroréfléchissant.

**6.** Source laser monomode continûment accordable en longueur d'onde selon l'une quelconque des revendications 1 à 5, **caractérisée en ce que** le contrôle et la modulation de $\lambda_e$ - $\lambda_s$ sont obtenus par le contrôle et la modulation de la longueur d'onde $\lambda_s$ du maximum de la courbe de sélectivité du dispositif dispersif rétroréfléchissant.

**7.** Source laser monomode continûment accordable en longueur d'onde selon la revendication 6, **caractérisée en ce que** le contrôle et la modulation de la longueur d'onde d'émission $\lambda_s$ sont obtenus par une rotation de l'un des éléments du dispositif dispersif rétroréfléchissant.

**8.** Source laser monomode continûment accordable en longueur d'onde selon la revendication 7, **caractérisée en ce que** le dispositif dispersif rétroréfléchissant comprend un réflecteur et le contrôle et la modulation de la longueur d'onde $\lambda_s$ sont obtenus par la rotation additionnelle du réflecteur.

**9.** Source laser monomode continûment accordable en longueur d'onde selon l'une quelconque des revendications 1 à 5, **caractérisée en ce que** le contrôle et la modulation de $\lambda_e$ - $\lambda_s$ sont obtenus par le contrôle et la modulation de la longueur d'onde $\lambda_e$.

**10.** Source laser monomode continûment accordable en longueur d'onde selon la revendication 9, **caractérisée en ce que** le contrôle et la modulation de la longueur d'onde d'émission $\lambda_e$ sont obtenus par une translation additionnelle de l'un des éléments de la cavité résonnante.

**11.** Source laser monomode continûment accordable en longueur d'onde selon la revendication 10, **caractérisée en ce que** le dispositif dispersif rétroréfléchissant comporte un réflecteur, le contrôle et la modulation de la longueur d'onde d'émission $\lambda_e$ sont obtenus par une translation additionnelle dudit réflecteur.

**12.** Source laser monomode continûment accordable en longueur d'onde selon l'une quelconque des revendications 1 à 5, **caractérisée en ce que** le contrôle et la modulation de $\lambda_e$ - $\lambda_s$ sont obtenus par le contrôle et la modulation de la position transverse, parallèlement au plan de dispersion, de l'optique de collimation (64).

**Claims**

**1.** An external cavity, continuously wavelength-tunable monomode laser source comprising a resonant cavity, resonating at the emission wavelength $\lambda$e, having:

- a spatially monomode, amplifying wave guide, located inside the resonant cavity, whereas the said wave guide has an intracavity face treated with an antireflection coat,
- collimation optics with a focus, whereby the intracavity face of the wave guide is located at the focus of these optics,
- a partially reflection output face,
- extraction means of a portion of the intracavity flux,
- a retroreflecting wavelength dispersing device controlled in position and in orientation, arranged with respect to the wave guide and to the collimation optics so that it provides a wavelength selectivity curve with a maximum for $\lambda$s, and
- primary mechanical means allowing to obtain essentially a continuous tunability,

**characterised in that** it comprises additional fine-control means, enabling from the approximate continuous tunability position, to monitor the deviation $\lambda$e - $\lambda$s during the variation of the emission wavelength $\lambda$e while preventing this deviation from reaching one of the limits causing mode rise.

**2.** A continuously wavelength-tunable monomode laser source according to claim 1, **characterised in that** the fine-control means act at least on one of the position and/or the orientation of the retroreflecting device.

3. A continuously wavelength-tunable monomode laser source according to one of claims 1 and 2, **characterised in that** the control means comprise:

- a generator of modulation (48) λe - λs,
- an intensity demodulator (46) of the light flux measured which produces a demodulated signal used for automatic control of the position of the retroreflecting dispersing device.

4. A continuously wavelength-tunable monomode laser source according to one of claims 1 to 3, **characterised in that** the average deviation < λe - λs > is monitored to a preset value Δλo greater than zero with a controlled loop of the position and/or orientation of the retroreflecting dispersing device.

5. A continuously wavelength-tunable monomode laser source according to one of claims 1 to 3, **characterised in that** the average deviation < λe - λs > is reduced to zero with a controlled loop of the position and/or orientation of the retroreflecting dispersing device.

6. A continuously wavelength-tunable monomode laser source according to any one of claims 1 to 5, **characterised in that** control and modulation of λe - λs are obtained by controlling and modulating the wavelength λs of the maximum of the selectivity curve of the retroreflecting dispersing device.

7. A continuously wavelength-tunable monomode laser source according to claim 6, **characterised in that** control and modulation of the emission wavelength λs are obtained by rotation of one of the elements of the retroreflecting dispersing device.

8. A continuously wavelength-tunable monomode laser source according to claim 7, **characterised in that** the retroreflecting dispersing device comprises a reflector and control and modulation of the wavelength λs are obtained by additional rotation of the reflector.

9. A continuously wavelength-tunable monomode laser source according to any one of claims 1 to 5, **characterised in that** control and modulation of λe - λs are obtained by controlling and modulating the wavelength λe.

10. A continuously wavelength-tunable monomode laser source according to claim 9, **characterised in that** control and modulation of the emission wavelength λe are obtained by additional translation of one of the elements of the resonant cavity.

11. A continuously wavelength-tunable monomode laser source according to claim 10, **characterised in that** the retroreflecting dispersing device comprises a reflector, whereas control and modulation of the emission wavelength λe are obtained by additional translation of the said reflector.

12. A continuously wavelength-tunable monomode laser source according to any one of claims 1 to 5, **characterised in that** control and modulation of λe - λs are obtained by controlling and modulating the transversal position, parallel to the dispersion plane, of the collimation optics (64).

**Patentansprüche**

1. Monomode Laserquelle mit externem Resonator mit stufenlos abstimmbarer Wellenlänge, mit einem bei einer Sendewellenlänge $\lambda_e$ resonanten Hohlraumresonator, umfassend:

- einen räumlich monomoden Verstärkerwellenleiter, welcher im Inneren des Resonators angeordnet ist, wobei der genannte Wellenleiter einen stirnseitigen Innenraum aufweist, welcher mit einer antireflektierenden Schicht überzogen ist,

- eine Kollimatoroptik mit einem Brennpunkt, wobei der genannte Innenraum des Wellenleiters im Brennpunkt dieser Optik angeordnet ist,

- eine teilweise reflektierende Ausgangsseite,

- Extraktionsmittel eines Teils des Flusses des Innenraumes,

- eine nach Wellenlänge retroreflektierende Streuvorrichtung, welche in Position und/oder Orientierung gesteuert werden kann, welche zum Wellenleiter und zur Kollimatoroptik in einer Weise angeordnet ist, dass die Vorrichtung eine Selektivitätskurve der Wellenlänge, mit einem Maximalwert für $\lambda_s$ erzeugt, und

- primäre mechanische Mittel, welche eine ungefähr stufenlose Einstellbarkeit ermöglichen,

**dadurch gekennzeichnet, dass** die Laserquelle zusätzliche Endkontrollmittel aufweist, welche ausgehend von der ungefähren stufenlosen Einstellbarkeitsposition erlauben, die Abweichung $\lambda_e$ - $\lambda_s$ während der Änderung der Sendewellenlänge $\lambda_e$ zu kontrollieren, wobei vermieden wird, dass diese Abweichung einen Grenzwert erreicht, welcher einen Modussprung hervorrufen würde.

2. Monomode Laserquelle mit stufenlos einstellbarer Wellenlänge nach Anspruch 1, **dadurch gekenn-**

**zeichnet, dass** die Endkontrollmittel an mindestens einer der Stellen und/oder der Orientierung der retroreflektierenden Vorrichtung angreifen.

3. Monomode Laserquelle mit stufenlos einstellbarer Wellenlänge nach Anspruch 1 oder 2, **dadurch gekennzeichnet, dass** die Kontrollmittel aufweisen:

   - einen Modulationsgenerator (48) für $\lambda_e - \lambda_s$,

   - einen Demodulator (46) der Intensität des gemessenen Lichtflusses, welcher ein demoduliertes Signal erzeugt, um die Position der retroreflektierenden Streuvorrichtung zu steuern.

4. Monomode Laserquelle mit stufenlos einstellbarer Wellenlänge nach Anspruch 1, **dadurch gekennzeichnet, dass** die Durchschnittsabweichung <$\lambda_e - \lambda_s$> zu einem Soll-Wert $\Delta\lambda_0 > 0$ mittels einer Regelschleife für die Position und/oder die Orientierung der retroreflektierenden Streuvorrichtung gebracht wird.

5. Monomode Laserquelle mit stufenlos einstellbarer Wellenlänge nach Anspruch 1, **dadurch gekennzeichnet, dass** die Durchschnittsabweichung <$\lambda_e - \lambda_s$> bis auf 0 mittels einer Regelschleife für die Position und/oder die Orientierung der retroreflektierenden Streuvorrichtung reduziert wird.

6. Monomode Laserquelle mit stufenlos einstellbarer Wellenlänge nach Anspruch 1, **dadurch gekennzeichnet, dass** die Kontrolle und die Modulation von $\lambda_e - \lambda_s$ durch die Kontrolle und die Modulation der Wellenlänge $\lambda_s$ des Maximalwerts der Selektivitätskurve der retroreflektierenden Streuvorrichtung erhalten werden.

7. Monomode Laserquelle mit stufenlos einstellbarer Wellenlänge nach Anspruch 1, **dadurch gekennzeichnet, dass** die Kontrolle und die Modulation der Wellenlänge $\lambda_s$ durch die Rotation eines der Elemente der retroreflektierenden Streuvorrichtung erhalten werden.

8. Monomode Laserquelle mit stufenlos einstellbarer Wellenlänge nach Anspruch 1, **dadurch gekennzeichnet, dass** die retroreflektierende Streuvorrichtung einen Reflektor aufweist und dass die Kontrolle und die Modulation der Wellenlänge $\lambda_s$ durch die zusätzliche Rotation des Reflektors erhalten werden.

9. Monomode Laserquelle mit stufenlos einstellbarer Wellenlänge nach Anspruch 1, **dadurch gekennzeichnet, dass** die Kontrolle und die Modulation von $\lambda_e - \lambda_s$ durch die Kontrolle und die Modulation der Wellenlänge $\lambda_e$ erhalten werden.

10. Monomode Laserquelle mit stufenlos einstellbarer Wellenlänge nach Anspruch 1, **dadurch gekennzeichnet, dass** die Kontrolle und die Modulation der Sendewellenlänge $\lambda_e$ durch eine zusätzliche Translation eines der Elemente des Resonators erhalten werden.

11. Monomode Laserquelle mit stufenlos einstellbarer Wellenlänge nach Anspruch 1, **dadurch gekennzeichnet, dass** die retroreflektierende Streuvorrichtung einen Reflektor aufweist und dass die Kontrolle und die Modulation der Sendewellenlänge $\lambda_e$ durch eine zusätzliche Translation des genannten Reflektors erhalten werden.

12. Monomode Laserquelle mit stufenlos einstellbarer Wellenlänge nach Anspruch 1, **dadurch gekennzeichnet, dass** die Kontrolle und die Modulation von $\lambda_e - \lambda_s$ durch die Kontrolle und die Modulation der transversalen Position, parallel zur Streuebene, der Kollimatoroptik (64) erhalten werden.

FIG. 1 ART ANTERIEUR

FIG. 2A
ART ANTERIEUR

FIG. 2B
ART ANTERIEUR

FIG. 4

FIG. 3 ART ANTERIEUR

FIG. 5

FIG. 6

FIG. 7

FIG. 8

FIG. 9

FIG. 10